# EUROPEAN PATENT APPLICATION

(11) **EP 4 481 506 A1**
(43) Date of publication of application: **25.12.2024**
(21) Application number: 24183616.2
(22) Date of filing: 21.06.2024
(51) Int. Cl.: G04B 13/02, G04D 3/00, B81C 99/00, C25D 1/00

(54) **METHOD OF MANUFACTURING WHEEL FOR TIMEPIECE, PLATE-SHAPED MEMBER, WHEEL FOR TIMEPIECE, AND TIMEPIECE**

(30) Priority: 23.06.2023 JP 2023103171
(71) Applicant: Seiko Epson Corporation, Tokyo 160-8801 (JP)
(72) Inventor: FUNAKAWA, Takeo, Suwa-shi, 392-8502 (JP); NAGASAKA, Eiichi, Suwa-shi, 392-8502 (JP)
(74) Representative: Lewis Silkin LLP

(57) **Abstract**

A method of manufacturing a wheel includes an outer shape formation process in which etching is performed or a silicon wafer made of a brittle material to form the wheel including a plurality of teeth, a frame portion that is disposed outside the wheel, and a coupling portion that is more flexible than the teeth and couples the frame portion to a leading end portion of a corresponding one of the teeth, and a cutting process in which the coupling portion and the wheel are cut.

## Description

The present application is based on, and claims priority from JP Application Serial Number 2023-103171, filed June 23, 2023, the disclosure of which is hereby incorporated by reference herein in its entirety.

### BACKGROUND

### 1. Technical Field

The present disclosure relates to a method of manufacturing a wheel for a timepiece, a plate-shaped member, a wheel for a timepiece, and a timepiece.

### 2. Related Art

In JP-A-2020-46348, a method of manufacturing a wheel for a timepiece using a silicon wafer, which is a brittle material, is described. In this manufacturing method, etching is performed on a silicon wafer to form a wheel, a frame portion that is disposed outside the wheel, and a tie bar that couples the wheel to the frame portion. In addition, when the wheel and the tie bar are cut, the wheel is taken out. Before being cut, the tie bar is coupled to an outer peripheral surface between teeth of the wheel.

However, in JP-A-2020-46348, there is a problem in which, since the tie bar is coupled between the teeth, it is difficult to apply the manufacturing method to a wheel not having such a large interval between teeth, such as a wheel that meshes with another wheel. Specifically, in a wheel having a small interval between teeth, it is difficult to provide a tie bar, and in addition, when a portion, where the tie bar is cut, projects, the wheel may not be able to normally mesh with another wheel.

### SUMMARY

A method of manufacturing a wheel for a timepiece includes performing etching on a plate-shaped member made of a brittle material to form a wheel for a timepiece including a plurality of teeth, a frame portion that is disposed outside the wheel for a timepiece, and a coupling portion that is more flexible than the teeth and couples the frame portion to a leading end portion of a corresponding one of the teeth, and cutting the coupling portion and the wheel for a timepiece.

A plate-shaped member made of a brittle material includes a wheel for a timepiece including a plurality of teeth, a frame portion that is disposed outside the wheel for a timepiece, and a coupling portion that is more flexible than the teeth and couples the frame portion to a leading end portion of a corresponding one of the teeth.

A wheel for a timepiece generated by being cut from a plate-shaped member made of a brittle material includes a plurality of teeth, and the plurality of teeth includes a tooth that has a cut surface, in a leading end portion, that is formed when the wheel for a timepiece is cut from the plate-shaped member.

A timepiece includes the above-described wheel for a timepiece.

### BRIEF DESCRIPTION OF THE DRAWINGS

FIG. 1 is a plan view of a movement of a mechanical timepiece viewed from a front side.
FIG. 2 is a plan view illustrating a configuration of a third wheel.
FIG. 3 is a plan view illustrating a silicon wafer after being etched.
FIG. 4 is an enlarged plan view in which one wheel included in the silicon wafer is enlarged.
FIG. 5 is an enlarged plan view illustrating a coupling portion.
FIG. 6 is a flowchart illustrating a method of manufacturing a wheel.
FIG. 7 is a process sectional view for explaining the method of manufacturing the wheel.
FIG. 8 is a process sectional view for explaining the method of manufacturing the wheel.
FIG. 9 is a process sectional view for explaining the method of manufacturing the wheel.
FIG. 10 is a process sectional view for explaining the method of manufacturing the wheel.
FIG. 11 is a process sectional view for explaining the method of manufacturing the wheel.
FIG. 12 is a process sectional view for explaining the method of manufacturing the wheel.
FIG. 13 is a process sectional view for explaining the method of manufacturing the wheel.
FIG. 14 is a process sectional view for explaining the method of manufacturing the wheel.
FIG. 15 is a process sectional view for explaining the method of manufacturing the wheel.
FIG. 16 is an explanatory view illustrating a schematic configuration of an anisotropic etching apparatus.
FIG. 17 is a flowchart illustrating a method of manufacturing a mechanical timepiece.
FIG. 18 is an enlarged plan view illustrating a coupling portion according to a modification.
FIG. 19 is an enlarged plan view illustrating a coupling portion according to a modification.
FIG. 20 is an enlarged plan view illustrating a coupling portion according to a modification.
FIG. 21 is an enlarged plan view in which one wheel included in a silicon wafer according to a modification is enlarged.

### DESCRIPTION OF EMBODIMENTS

Hereinafter, a timepiece, a wheel for a timepiece, and a method of manufacturing the timepiece and the wheel for a timepiece of the present embodiment will be described with reference to the drawings. In the drawings referred to below, in order to show layers and members in recognizable sizes, scales of the layers and the members may be set different from actual scales.

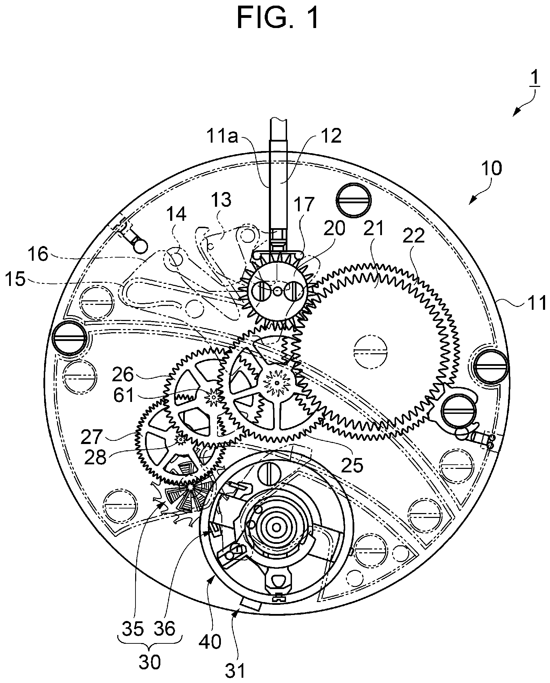

FIG. 1 is a plan view of a movement 10 of a mechanical timepiece 1 viewed from a front side. In the present embodiment, a rear side is a side on which a hand indicating a time is disposed, and a front side is a side on which a spring that drives the hand, and the like are disposed. A forward side of the page in FIG. 1 is a front side, and a rearward side of the page is a rear side.

The mechanical timepiece 1 includes the movement 10 illustrated in FIG. 1 and a casing (not illustrated) that accommodates the movement 10. The mechanical timepiece 1 is an example of a timepiece.

The movement 10 includes a main plate 11. The main plate 11 is a plate member for supporting each component and determining a position. A dial (not illustrated) is disposed on the rear side of the main plate 11. A wheel train including a plurality of wheels is disposed on each of the front side and the rear side of the main plate 11. The wheel train disposed on the front side of the main plate 11 is also referred to as a front wheel train, and the wheel train disposed on the rear side of the main plate 11 is also referred to as a rear wheel train.

In the main plate 11, in a direction parallel to the main plate 11 and extending toward a center from an outer edge, a winding stem guide hole 11a that guides a shaft-shaped winding stem 12 is formed. In addition, the winding stem 12 is incorporated in the winding stem guide hole 11a so as to be able to move in an axial direction and rotate around the axis. A setting lever 13, a yoke 14, a yoke spring 15, and a setting lever jumper 16 are disposed near the winding stem 12. The setting lever 13, the yoke 14, the yoke spring 15, and the setting lever jumper 16 constitute a switching mechanism that switches a transmission destination of a rotational force of the winding stem 12.

The winding stem 12 is inserted into a winding pinion 17 that is rotatable around the same axis as the winding stem 12. In addition, in the winding stem 12, a clutch wheel (not illustrated) that is rotated together with the winding stem 12 is disposed. The clutch wheel is rotatable around the same axis as the winding stem 12 and is also movable in the axial direction of the winding stem 12 by the switching mechanism. When the winding stem 12 changes its position in the axial direction, the switching mechanism switches between a state in which the clutch wheel meshes with the winding pinion 17 and a state in which the clutch wheel does not mesh with the winding pinion 17. In addition, in the main plate 11, a crown wheel 20 that meshes with the winding pinion 17, a ratchet wheel 21 that meshes with the crown wheel 20, and a barrel wheel 22 that accommodates a spring are rotatably installed.

When the winding stem 12 moves in the axial direction and is disposed at a first winding stem position nearest a center of the movement 10, the clutch wheel meshes with the winding pinion 17. When an operator rotates the winding stem 12 in this state, the winding pinion 17 is rotated together with the clutch wheel. Then, when the winding pinion 17 is rotated, the crown wheel 20 is rotated. Then, when the crown wheel 20 is rotated, the ratchet wheel 21 is rotated. Furthermore, when the ratchet wheel 21 is rotated, the spring accommodated in the barrel wheel 22 is wound up. The spring is a power source for driving the movement 10. Note that when the winding stem 12 is disposed further on an outer side than is the first winding stem position, meshing of the clutch wheel with the winding pinion 17 is released, and the clutch wheel meshes with a setting wheel (not illustrated) for performing time adjustment, or the like.

On the main plate 11, a second wheel 25, a third wheel 26, and a fourth wheel 27 are rotatably disposed. The second wheel 25, the third wheel 26, and the fourth wheel 27 each include a wheel and a pinion that integrally rotate. The above-described front wheel train is composed of the barrel wheel 22, the second wheel 25, the third wheel 26, and the fourth wheel 27. The front wheel train has a function of transmitting a rotational force of the barrel wheel 22. In addition, on the front side of the movement 10, an escapement mechanism 30 and a speed control mechanism 31 are disposed on the main plate 11. The escapement mechanism 30 and the speed control mechanism 31 adjust a rotation speed of the front wheel train.

The pinion of the second wheel 25 meshes with the barrel wheel 22. A minute hand (not illustrated) is coupled to the second wheel 25. The pinion of the third wheel 26 meshes with the wheel of the second wheel 25. The pinion of the fourth wheel 27 meshes with the wheel of the third wheel 26. A second hand (not illustrated) is coupled to the fourth wheel 27. The escapement mechanism 30 is a mechanism that controls the rotation of the front wheel train. The escapement mechanism 30 includes an escape wheel 35 and a pallet fork 36. The escape wheel 35 includes a pinion that meshes with the wheel of the fourth wheel 27 and is rotated by receiving torque of the fourth wheel 27. The pallet fork 36 rotates the escape wheel 35 regularly according to the movement of the speed control mechanism 31. The speed control mechanism 31 includes a balance with a hairspring 40 that swings at a fixed cycle, and the like, and adjusts the rotation speed of the escape wheel 35 so as to adjust the rotation speed of the front wheel train that meshes with the escape wheel 35.

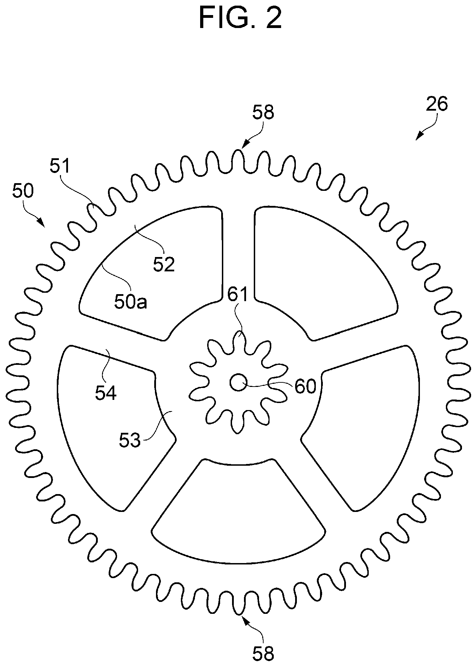

Next, among the above-described various components, the third wheel 26 will be described in detail. FIG. 2 is a plan view illustrating a configuration of the third wheel 26. As illustrated in FIG. 2, the third wheel 26 includes a wheel 50 and a shaft portion 60 serving as a rotary shaft of the wheel 50. The wheel 50 includes an annular rim portion 52 including a plurality of teeth 51 on an outer peripheral surface, a holding portion 53 through which the shaft portion 60 is inserted, and a plurality of coupling portions 54 that radially extends from the holding portion 53 and couples the rim portion 52 to the holding portion 53. In the wheel 50, an opening portion 50a surrounded by the rim portion 52, the holding portion 53, and two adjacent coupling portions 54 is formed. Specifically, in the wheel 50, the same number of the opening portions 50a as the number of the coupling portions 54 are formed in a circumferential direction. The wheel 50 meshes with a pinion 28 (see FIG. 1) included in the fourth wheel 27. The wheel 50 is an example of a wheel for a timepiece.

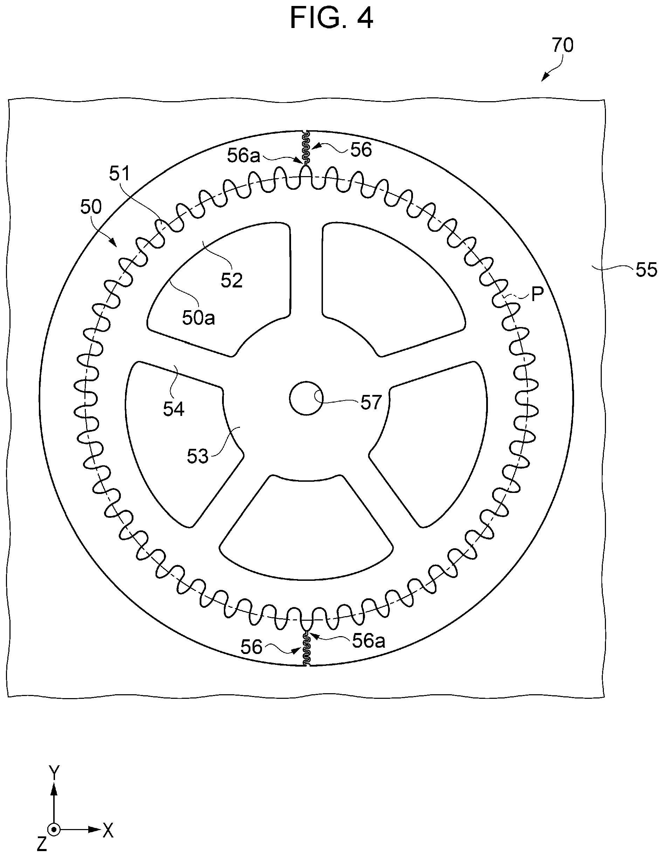

In the shaft portion 60, a pinion 61 that meshes with the wheel of the second wheel 25 is integrally formed. The shaft portion 60 is inserted into a hole portion 57 (see FIG. 4) formed in a center of the wheel 50 and is fixed to the wheel 50. Therefore, the wheel 50 is rotated integrally with the pinion 61.

The wheel 50 has a plate shape and has a substantially uniform thickness over the entire surface. The wheel 50 is made of a brittle material having a crystal orientation such as single crystal silicon. The material of the wheel 50 of the present embodiment is single crystal silicon. Specifically, the wheel 50 is formed through performing of etching on a silicon wafer made of single crystal silicon. A method of manufacturing the wheel 50 will be described later.

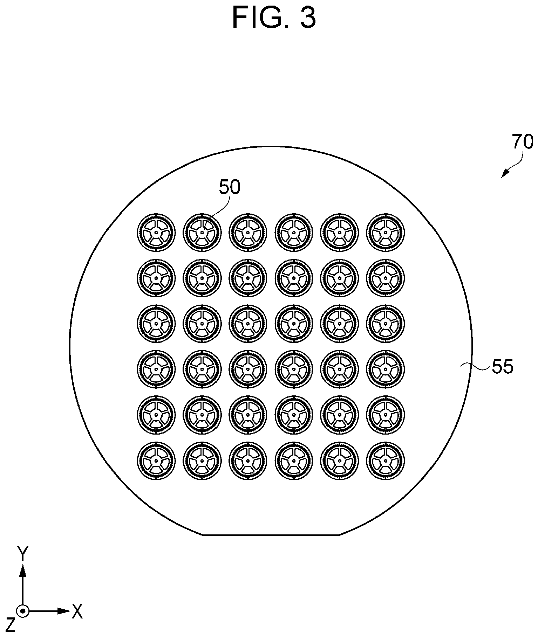

FIG. 3 is a plan view illustrating a silicon wafer 70 after being etched. FIG. 4 is an enlarged plan view in which one wheel 50 is enlarged. In FIGS. 3 and 4, an X axis, a Y axis, and a Z axis orthogonal to each other are illustrated. The X axis is a coordinate axis parallel to a surface of the silicon wafer 70. The Y axis is a coordinate axis parallel to the surface of the silicon wafer 70 and orthogonal to the X axis. The Z axis is a coordinate axis orthogonal to the surface of the silicon wafer 70, that is, an XY plane. Hereinafter, a direction parallel to the XY plane is also referred to as a plane direction, and a direction intersecting with the XY plane is also referred to as an intersecting direction.

As illustrated in FIG. 3, the silicon wafer 70 is a disk-shaped mother substrate capable of forming a plurality of the wheels 50. The silicon wafer 70 is an example of a plate-shaped member. In one silicon wafer 70, the plurality of wheels 50 is arranged in a matrix along the X axis and the Y axis. Each wheel 50 is surrounded by a frame portion 55 that is continuous to a peripheral edge portion of the silicon wafer 70. That is, the frame portion 55 is disposed outside the wheel 50.

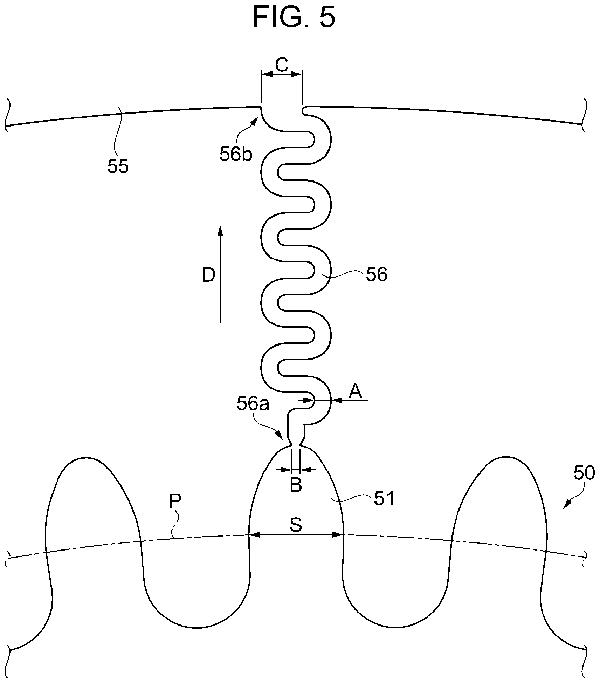

In the present embodiment, a dimension of the silicon wafer 70 in a direction extending along the Z axis, that is, a thickness of the silicon wafer 70 is approximately 100 µm to 200 µm. The thickness of the silicon wafer 70 corresponds to a tooth width of the wheel 50. In addition, a diameter of an addendum circle (not illustrated), that is, a circle passing leading ends of the teeth 51 is approximately 5 mm to 6 mm, and a tooth thickness S (see FIG. 5), that is, a dimension of each tooth 51 along a pitch circle P is approximately 100 µm to 200 µm. However, the tooth width, the diameter of the addendum circle, and the tooth thickness S are not limited to being within the above-described ranges, and may be outside the above-described ranges.

The wheel 50 is coupled to the frame portion 55 with a coupling portion 56 interposed therebetween. That is, the coupling portion 56 couples the wheel 50 to the frame portion 55, and the wheel 50 is supported by the frame portion 55 via the coupling portion 56. The coupling portions 56 are coupled to leading end portions of two teeth 51 among the plurality of teeth 51 included in the wheel 50. In the present embodiment, an angle formed by extending directions of the two teeth 51 to which the coupling portions 56 are coupled is approximately 180°.

FIG. 5 is an enlarged plan view illustrating the coupling portion 56. As illustrated in FIG. 5, the coupling portion 56, as a whole, extends from a leading end portion of the tooth 51 in substantially the same direction as the extending direction of the tooth 51 and reaches the frame portion 55. That is, when an end portion, of both ends of the coupling portion 56, that is coupled to the leading end portion of the tooth 51 is a first end portion 56a, and an end portion that is coupled to the frame portion 55 is a second end portion 56b, a direction D extending from the first end portion 56a toward the second end portion 56b is substantially equal to the extending direction of the tooth 51.

The shape of the coupling portion 56 when viewed along the Z axis is a meandering shape, that is, a wavy line shape. That is, in the plan view illustrated in FIG. 5, the coupling portion 56 extends in the direction D while alternately repeating counterclockwise bending and clockwise bending. Therefore, the shape of the coupling portion 56 can be also rephrased as a shape that is alternately bent in mutually opposite directions.

A width A of the coupling portion 56 corresponding to a line width of the wavy line is approximately uniform as a whole in a range excluding the first end portion 56a and the second end portion 56b. In the present embodiment, the width A of the coupling portion 56 is approximately 30 µm and is substantially small compared to the tooth thickness S of the tooth 51. In the first end portion 56a, a narrow portion is formed. Therefore, the first end portion 56a has a small width compared to other portions of the coupling portion 56. Specifically, the first end portion 56a is wedged and has a smaller width toward a leading end. That is, a width B of the leading end of the first end portion 56a is smaller than the width A of the coupling portion 56. On the other hand, a width C of the second end portion 56b is larger than the width A of the coupling portion 56.

The coupling portion 56 is flexible and can be bent in a plane direction parallel to the XY plane. The tooth 51 of the wheel 50 can be technically flexible, but since the width A of the coupling portion 56 is substantially small compared to the tooth thickness S of the tooth 51, the coupling portion 56 is substantially flexible compared to the tooth 51. The width A of the coupling portion 56 is preferably as small as possible in terms of improving of the flexibility. On the other hand, when the width A of the coupling portion 56 is made too small, it becomes difficult to form the coupling portion 56 by etching. Therefore, the width A of the coupling portion 56 is preferably 10 µm to 50 µm, and is more preferably 20 µm to 40 µm.

The wheel 50 in a state of being coupled to the frame portion 55 with the coupling portion 56 interposed therebetween is cut in the first end portion 56a of the coupling portion 56 so as to be separated from the silicon wafer 70. Therefore, in the wheel 50 after being separated, a cut surface 58 is formed in the leading end portion of each of the two teeth 51 that have been coupled to the coupling portions 56 (see FIG. 2). That is, the cut surface 58 is a surface that has been coupled to the first end portion 56a of the respective coupling portions 56. The cut surface 58 can project further on an outer side than is the leading end portion of the tooth 51, but as long as the projection does not come into contact with the pinion 28 of the fourth wheel 27, which is a target pinion to be meshed with, the projection does not affect the operation.

Note that single crystal silicon, which is the material of the wheel 50, includes a plurality of crystal planes and has a property of being easily cleaved along a crystal plane. That is, single crystal silicon can be cut with a small force when being cut along a crystal plane, compared to a case of being cut along a plane other than a crystal plane. In addition, when single crystal silicon is cut along a crystal plane, spreading of a crack, generated by cutting, in a direction other than the direction of the crystal plane is suppressed. Therefore, both front and rear surfaces of the wheel 50 parallel to the XY plane and two cut surfaces 58 coupled to the coupling portions 56 are preferably crystal planes.

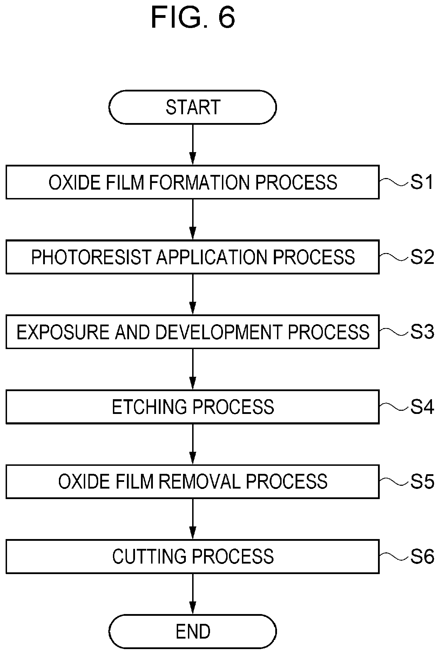

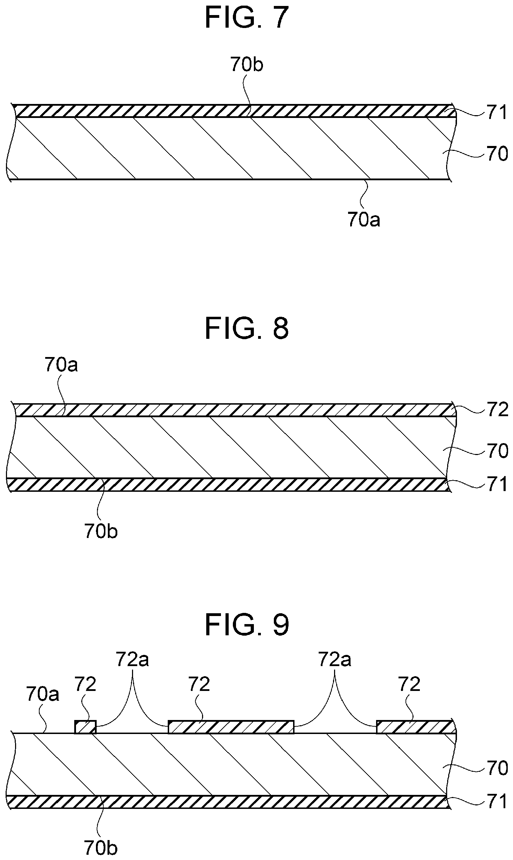

Next, a method of manufacturing the wheel 50 included in the third wheel 26 will be described. FIG. 6 is a flowchart illustrating a method of manufacturing the wheel 50, and FIGS. 7 to 15 are process sectional views for explaining the method of manufacturing the wheel 50. As illustrated in FIG. 6, the method of manufacturing the wheel 50 includes each process of steps S1 to S6. That is, the wheel 50 is manufactured through implementing of each process of steps S1 to S6 in sequence.

Step S1 is an oxide film formation process. As illustrated in FIG. 7, in this process, a silicon oxide film 71 is formed on one plane of the silicon wafer 70. The silicon wafer 70 is ground in advance to have an appropriate thickness so that the tooth width of the wheel 50 has a desired dimension, and a surface of the silicon wafer 70 is polished.

The silicon wafer 70 has two planes, which are a first surface 70a and a second surface 70b, on the front and rear sides. In step S1, the silicon oxide film 71 is formed on the second surface 70b. For formation of the silicon oxide film 71, a chemical vapor deposition (CVD) method is used. A film thickness of the silicon oxide film 71 is not particularly limited, but is, for example, approximately 1 µm. The silicon oxide film 71 is formed in order to suppress penetration of a hole 70c, which is formed in an etching process in step S4 described later, through the front and rear sides.

Step S2 is a photoresist application process. As illustrated in FIG. 8, in this process, a resist film 72 is formed on the first surface 70a of the silicon wafer 70. First, a resin solution, in which a photosensitive resin is dissolved, is applied to the first surface 70a of the silicon wafer 70 by a spin coating method, a spray coating method, or the like. Next, the resin solution is dried to remove a solvent so as to form the resist film 72. For the photosensitive resin, either a negative or positive material may be adopted.

Step S3 is an exposure and development process. In this process, an etching mask for forming the wheel 50 is formed. First, using a photomask, in which a pattern corresponding to the plurality of wheels 50, the frame portion 55, and a plurality of the coupling portions 56 coupling the plurality of wheels 50 to the frame portion 55, as illustrated in FIG. 3, is formed, exposure is performed on the resist film 72. Then, after development is performed to remove unnecessary portions of the resist film 72, in the resist film 72, as illustrated in FIG. 9, opening portions 72a corresponding to the pattern of the photomask are formed. The opening portions 72a correspond to portions of silicon to be removed from the silicon wafer 70 by etching. That is, the resist film 72, in which the opening portions 72a are formed, functions as an etching mask.

Step S4 is an etching process. In this process, through performing of etching on the silicon wafer 70 using the resist film 72 as an etching mask, shapes of the wheels 50, the frame portion 55, and the coupling portions 56 are formed. For etching, for example, anisotropic etching such as deep reactive ion etching (DRIE) by inductively coupled plasma (ICP), or the like is used.

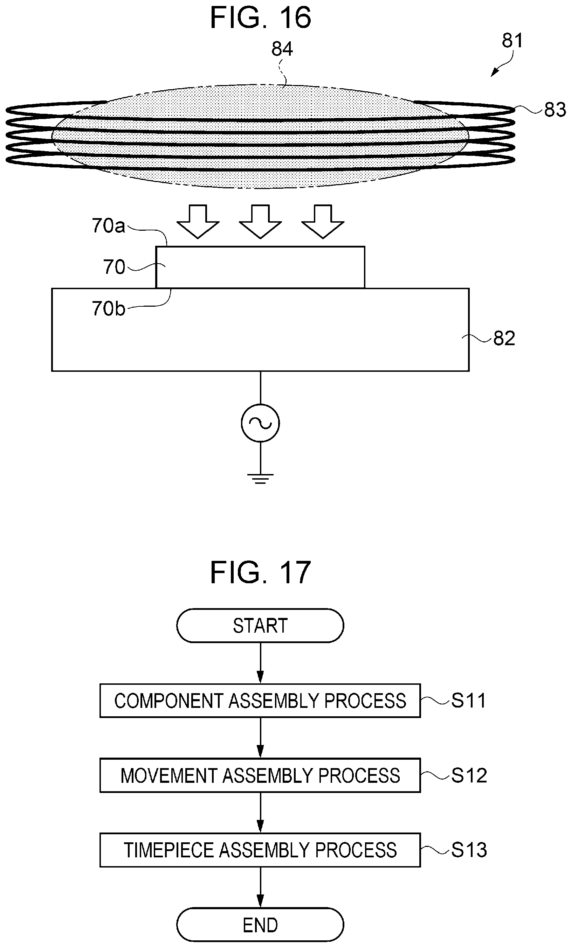

FIG. 16 is an explanatory view illustrating a schematic configuration of an anisotropic etching apparatus 81 that performs DRIE by ICP. As illustrated in FIG. 16, the anisotropic etching apparatus 81 includes a stage 82 and a coil 83. On the stage 82, the silicon wafer 70 is mounted such that the first surface 70a, on which the resist film 72 is formed, faces the coil 83 side. The anisotropic etching apparatus 81 causes a high current with high frequency to flow through the coil 83 while supplying an SF₆ gas so as to generate plasma 84. Then, when the stage 82 is biased, particles of the plasma 84 are drawn onto the first surface 70a of the silicon wafer 70 from the opening portions 72a of the resist film 72. As a result, the silicon wafer 70 is substantially vertically etched in an intersecting direction into the shapes of the opening portions 72a from the first surface 70a side. Silicon on which etching is performed becomes SiF₄ and is removed. In order to prevent an excessive rise in the temperature of the silicon wafer 70, the anisotropic etching apparatus 81 cools the silicon wafer 70 from the second surface 70b side using helium gas, for example.

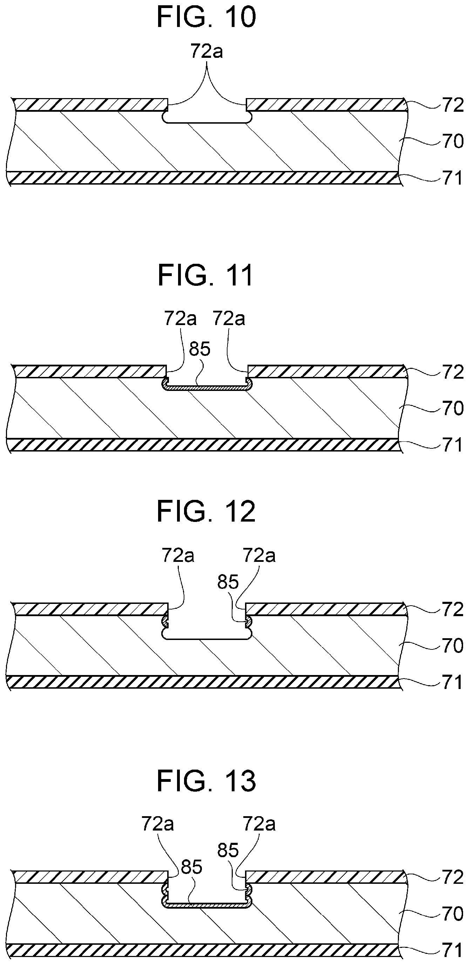

As illustrated in FIG. 10, when the silicon wafer 70 is scraped to have a predetermined depth, as illustrated in FIG. 11, the anisotropic etching apparatus 81 supplies a C₄F₈ gas to a surface of the silicon wafer 70 so as to form a protective film 85 on a surface to which silicon is exposed. Forming of the protective film 85 is also referred to as coating.

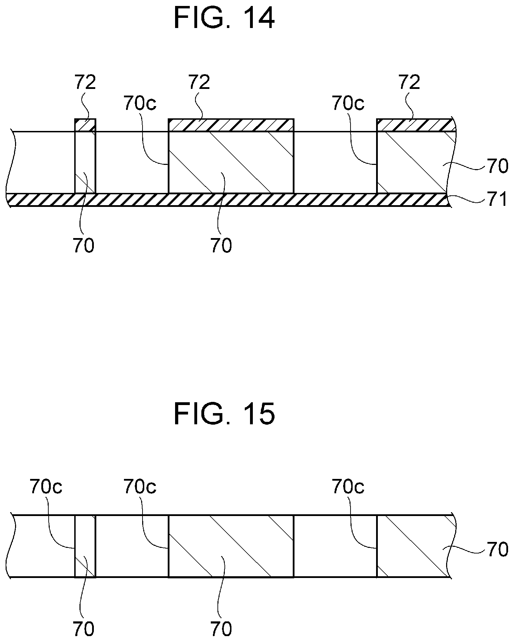

Then, as illustrated in FIG. 12, the anisotropic etching apparatus 81 performs etching on the silicon wafer 70 again so as to expose silicon and subsequently, as illustrated in FIG. 13, performs coating with the protective film 85 again. In this manner, the anisotropic etching apparatus 81 repeatedly performs etching on the silicon wafer 70 and coating with the protective film 85 a plurality of times. This method is called a Bosch process. By the Bosch process, as illustrated in FIG. 14, in the silicon wafer 70, the holes 70c that reach the silicon oxide film 71 are formed in portions not covered with the resist film 72. Here, the holes 70c include a gap between the wheel 50 and the frame portion 55, the opening portion 50a and the hole portion 57 formed inside the wheel 50.

Step S5 is an oxide film removal process. In this process, as illustrated in FIG. 15, the silicon oxide film 71 and the resist film 72 disposed on the silicon wafer 70 are removed. Removal of the resist film 72 can be performed by wet etching using fuming nitric acid, an organic solvent, or the like capable of dissolving and stripping the resist film 72, oxygen plasma ashing, or the like. In the present embodiment, after oxygen plasma ashing is performed, an organic stripping agent is further used to remove a residue.

Removal of the silicon oxide film 71 is performed by wet etching in which the silicon wafer 70 is immersed in a buffered hydrogen fluoride (BHF) solution. Note that removal of the silicon oxide film 71 may also be performed by reactive ion etching using a parallel plate.

As described above, by steps S1 to S5, the plurality of wheels 50 illustrated in FIG. 3, the frame portion 55, and the plurality of coupling portions 56 that couples the wheels 50 to the frame portion 55 are formed. That is, a series of processes including steps S1 to S5 is an outer shape formation process that forms the wheels 50, the frame portion 55, and the coupling portions 56 through performing of etching on the silicon wafer 70.

Step S6 is a cutting process. In this process, the coupling portions 56 and the wheels 50 are cut. The operation of cutting the coupling portions 56 and the wheels 50 is performed using a tool having a fine tip such as tweezers. Specifically, an operator mounts the silicon wafer 70 illustrated in FIGS. 3 and 4 on a worktable (not illustrated) and fixes the frame portion 55 to the worktable. Then, the operator inserts the tool into the opening portion 50a inside each wheel 50, and displaces the wheel 50 in the plane direction while keeping the tool in contact with the opening portion 50a. That is, the wheel 50 is displaced in the plane direction with respect to the frame portion 55 by the tool. At this time, the first end portion 56a of each coupling portion 56 is also displaced following the displacement of the wheel 50, but since the coupling portion 56 is bent due to the flexibility, the coupling portion 56 does not break in the middle thereof. In addition, when a force acting on the first end portion 56a reaches a predetermined value, the first end portion 56a breaks, and the coupling portion 56 and the wheel 50 are cut.

By step S6, the wheel 50 is separated from the silicon wafer 70, as a result of which the wheel 50 is completed. That is, the wheel 50 is generated by being cut from the silicon wafer 70. In addition, the cut surface 58 is formed in the leading end portion of each of the two teeth 51 to which the coupling portions 56 are coupled when the coupling portions 56 are cut from the silicon wafer 70. Therefore, the plurality of teeth 51 included in the wheel 50 includes the two teeth 51 each including the cut surface 58 in the leading end portion.

Note that the two coupling portions 56 may be cut one by one in sequence, but the two coupling portions 56 may be cut in a single operation. For example, when a shaft is inserted into the hole portion 57 at the center of the wheel 50 so that the wheel 50 is turned around the shaft, the two coupling portions 56 can be easily cut in a single operation. In addition, a direction in which the wheel 50 is displaced is not limited to the plane direction, and the coupling portions 56 may be cut through displacing of the wheel 50 in an intersecting direction.

Next, a method of manufacturing the mechanical timepiece 1 will be described. FIG. 17 is a flowchart illustrating a method of manufacturing the mechanical timepiece 1. As illustrated in FIG. 17, the method of manufacturing the mechanical timepiece 1 includes each process of steps S11 to S13. That is, the mechanical timepiece 1 is manufactured through implementing of each process of steps S11 to S13 in sequence.

Step S11 is a component assembly process in which various components constituting the mechanical timepiece 1 are assembled. For example, the third wheel 26, which is one component, is assembled through inserting of the shaft portion 60 into the hole portion 57 of the wheel 50 that is formed by the above-described steps S1 to S6. Components other than the third wheel 26 are also assembled where necessary.

Step S12 is a movement assembly process in which the movement 10 is assembled. This process includes a process in which various components such as the third wheel 26 are assembled in the main plate 11.

Step S13 is a timepiece assembly process in which the mechanical timepiece 1 is assembled. This process includes a process in which the movement 10 is accommodated in a casing (not illustrated). By the above-described processes, the mechanical timepiece 1 is completed.

As described above, according to the wheel 50, and the method of manufacturing the wheel 50 of the present embodiment, the following effects can be obtained.

According to the present embodiment, since each coupling portion 56 is coupled to a leading end portion of the tooth 51, even when an interval between the teeth 51 is small, the coupling portion 56 can be coupled to the wheel 50. In addition, since the coupling portion 56 is coupled to the leading end portion of the tooth 51, it is possible to suppress influences on meshing with another wheel by the cut surface 58 that is formed after the coupling portion 56 is cut.

Note that when the flexible coupling portion 56 is coupled between the teeth 51, in the cutting process of step S6, the bent coupling portion 56 may come into contact with the teeth 51. In this case, the coupling portion 56 may break in the middle thereof or may damage the teeth 51. On the other hand, in the present embodiment, since the coupling portion 56 is coupled to the leading end portion of the tooth 51, breakage of the coupling portion 56 in the middle thereof or damage to the teeth 51 in the cutting process can be suppressed.

In addition, when the coupling portion 56 is coupled between the teeth 51, the etching pattern becomes dense around the coupling portion 56. As a result, due to a micro-loading effect, a difference in shape may be generated between the teeth 51 around the coupling portion 56 and other teeth 51. On the other hand, in the present embodiment, since the coupling portion 56 is coupled to the leading end portion of a corresponding one of the teeth 51, the etching pattern being locally dense can be suppressed, and generation of a difference in shape between the teeth 51 can be suppressed.

In addition, according to the present embodiment, since the shape of the coupling portion 56 is a wavy line shape, compared to a case in which the shape is linear, the coupling portion 56 can be greatly bent.

In addition, according to the present embodiment, a narrow portion is formed in the first end portion 56a of the coupling portion 56. That is, since the first end portion 56a is narrower than other portions of the coupling portion 56, when the coupling portion 56 and the wheel 50 are cut, cutting can be easily performed in the first end portion 56a.

In addition, according to the present embodiment, in the cutting process of step S6, when the wheel 50 is displaced, the tool is brought into contact with the opening portion 50a without being brought into contact with the teeth 51. In this manner, since the tool is brought into contact with a portion other than the teeth 51 at the time of cutting, damage to the teeth 51 by the tool can be suppressed.

In addition, according to the silicon wafer 70 in which outer shapes of the wheel 50, the frame portion 55, and the coupling portion 56 are formed after passing through the outer shape formation process of the present embodiment, the wheel 50 that exhibits the above-described effects can be easily formed.

In addition, according to the mechanical timepiece 1 of the present embodiment, since the wheel 50 that exhibits the above-described effects is used, stable operation can be realized.

The above-described embodiment may be modified as follows.

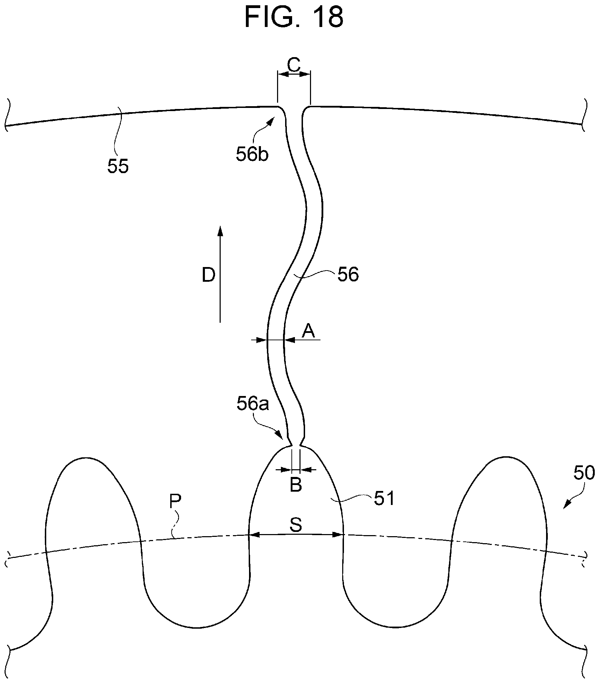

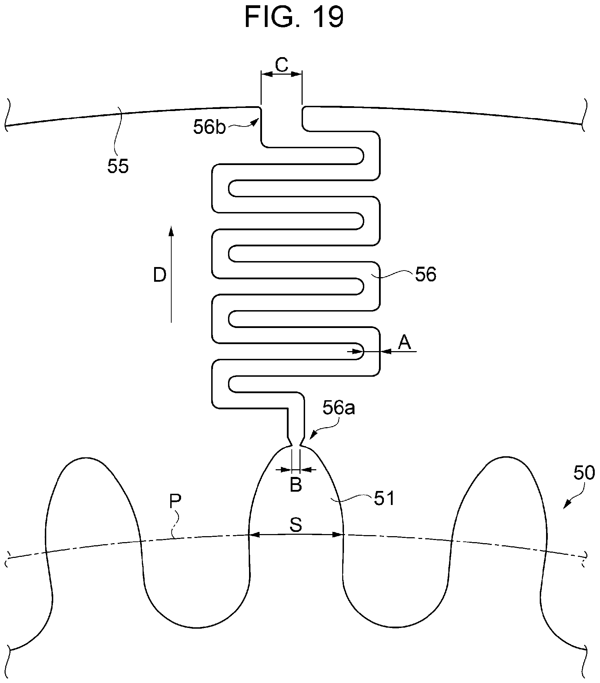

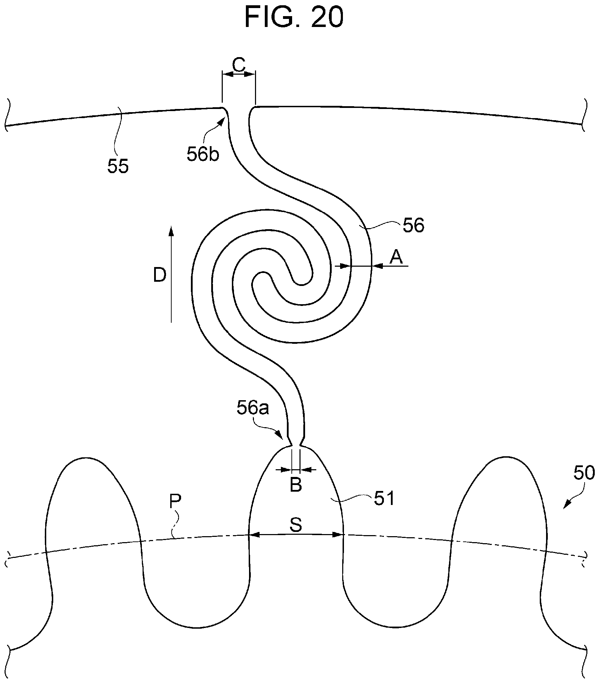

In the above-described embodiment, the shape of the coupling portion 56 is a wavy line shape, but the number of waves and the amplitude of waves of the wavy line are not limited to the aspect illustrated in FIG. 5. For example, as illustrated in FIG. 18, the number of waves may be less, and as illustrated in FIG. 19, the amplitude of waves may be larger. Note that the shape illustrated in FIG. 19 may be rephrased as a shape in which a linear portion is alternately bent in mutually opposite directions, or a shape in which a linear portion extending in a direction parallel to the XY plane and intersecting with the direction D extends in the direction D while being alternately bent in mutually opposite directions. In addition, the shape of the coupling portion 56 is not limited to a wavy line shape, and may be, as illustrated in FIG. 20, a curved line shape, which is different from a wavy line. In this manner, the coupling portion 56 only needs to follow, to some extent, the displacement of the wheel 50 in the plane direction by the flexibility, and the shape of the coupling portion 56 is not particularly limited.

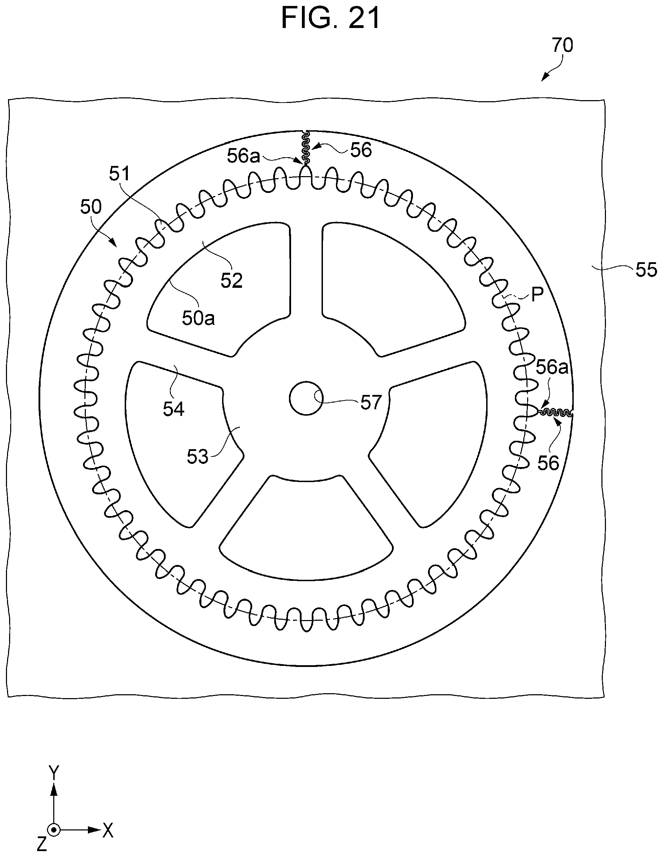

In the above-described embodiment, two coupling portions 56 are coupled to each wheel 50, and the angle formed by the extending directions of the two teeth 51 to which the coupling portions 56 are coupled is approximately 180°, but the angle is not limited thereto. For example, as illustrated in FIG. 21, the angle formed by the extending directions of the two teeth 51 to which the coupling portions 56 are coupled may be approximately 90°, or may be another angle. In addition, the number of the coupling portions 56 is not limited to two, and may be one, or three or more. In addition, in a configuration in which a plurality of the coupling portions 56 is coupled to one wheel 50, shapes or dimensions of the plurality of coupling portions 56 may be the same, or may be different.

In the above-described embodiment, the direction D extending from the first end portion 56a of the coupling portion 56 toward the second end portion 56b is approximately the same direction as the extending direction of the tooth 51 to which the coupling portion 56 is coupled, but the direction D may be a direction different from the extending direction of the tooth 51.

In the above-described embodiment, in the etching process of step S4, when the holes 70c are formed by a Bosch process, irregularities called scallops are formed on an etched surface. A process of removing the scallops may be additional executed. In this process, for example, after an oxide film having a depth of 1 µm or more is formed in the silicon wafer 70 by thermal oxidation, the silicon wafer 70 may be immersed in a BHF solution so as to perform etching on the oxide film.

In the above-described embodiment, in the component assembly process of step S11, after the shaft portion 60 is inserted into the wheel 50, an oxidation treatment, in which a silicon oxide film made of silicon dioxide (SiOz) is formed on a surface of the wheel 50, may be performed. When the oxidation treatment is performed on the wheel 50, mechanical strength of the wheel 50 is improved by the silicon oxide film formed on the surface of the wheel 50 made of a material containing silicon. When the oxidation treatment is performed, for example, a thermal oxidation treatment that is performed at a high temperature of 1000°C or more is preferably performed.

In the above-described embodiment, as the material of the wheel 50, silicon is used as a plate-shaped member made of a brittle material, but the material of the wheel 50 is not limited to silicon. For example, silicon carbide, quartz crystal, glass, sapphire, or the like may be used.

In the above-described embodiment, the wheel 50 of the third wheel 26 constituting the front wheel train of the mechanical timepiece 1 is exemplified, but the structure of the wheel 50 and the method of manufacturing the wheel 50 described in the above-described embodiment are applicable to various wheels such as other wheels constituting the front wheel train and wheels constituting the rear wheel train. In addition, the timepiece is not limited to the mechanical timepiece 1, and may be other timepieces such as an electronic timepiece. That is, the structure of the wheel 50 and the method of manufacturing the wheel 50 described in the above-described embodiment are applicable to wheels included in an electronic timepiece, or the like.

## Claims

1. A method of manufacturing a wheel for a timepiece comprising:
performing etching on a plate-shaped member made of a brittle material to form a wheel for a timepiece including a plurality of teeth, a frame portion that is disposed outside the wheel for a timepiece, and a coupling portion that is more flexible than the teeth and couples the frame portion to a leading end portion of a corresponding one of the teeth; and
cutting the coupling portion and the wheel for a timepiece.

2. The method of manufacturing a wheel for a timepiece according to claim 1, wherein the coupling portion has a width that is smaller than a tooth thickness of the tooth and has a curved line shape.

3. The method of manufacturing a wheel for a timepiece according to claim 1, wherein the coupling portion has a width that is smaller than a tooth thickness of the tooth and has a wavy line shape.

4. The method of manufacturing a wheel for a timepiece according to claim 1, wherein the coupling portion has a width that is smaller than a tooth thickness of the tooth and has a shape in which a linear portion is alternately bent in mutually opposite directions.

5. The method of manufacturing a wheel for a timepiece according to claim 1, wherein the coupling portion has a narrow portion in an end portion that is coupled to the leading end portion of the tooth.

6. The method of manufacturing a wheel for a timepiece according to claim 1, wherein
the cutting the coupling portion and the wheel for a timepiece includes cutting through displacing of the wheel for a timepiece with respect to the frame portion by a tool, and
the tool comes into contact with a portion other than the teeth of the wheel for a timepiece.

7. A plate-shaped member made of a brittle material comprising:
a wheel for a timepiece including a plurality of teeth;
a frame portion that is disposed outside the wheel for a timepiece; and
a coupling portion that is more flexible than the teeth and couples the frame portion to a leading end portion of a corresponding one of the teeth.

8. A wheel for a timepiece generated by being cut from a plate-shaped member made of a brittle material, the wheel for a timepiece comprising:
a plurality of teeth, wherein
the plurality of teeth includes a tooth that has a cut surface, in a leading end portion, that is formed when the wheel for a timepiece is cut from the plate-shaped member.

9. A timepiece comprising:
the wheel for a timepiece according to claim 8.
